Europäisches Patentamt

European Patent Office

Office européen des brevets

(11) Numéro de publication: **0 234 153**
**A1**

## (12) DEMANDE DE BREVET EUROPEEN

(21) Numéro de dépôt: 86402861.8

(51) Int. Cl.⁴: **H03H 9/05**

(22) Date de dépôt: 19.12.86

(30) Priorité: 24.12.85 FR 8519121

(43) Date de publication de la demande:
02.09.87 Bulletin 87/36

(84) Etats contractants désignés:
AT CH DE FR GB IT LI NL SE

(71) Demandeur: **COMPAGNIE D'ELECTRONIQUE
ET DE PIEZO-ELECTRICITE - C.E.P.E.
44, rue de la Glacière
F-95100 Argenteuil(FR)**

(72) Inventeur: **Fragneau, Marc
THOMSON-CSF SCPI 19, avenue de Messine
F-75008 Paris(FR)**
Inventeur: **Aubry, Jean-Pierre
THOMSON-CSF SCPI 19, avenue de Messine
F-75008 Paris(FR)**

(74) Mandataire: **Ruellan-Lemonnier, Brigitte et al
THOMSON-CSF SCPI 19, avenue de Messine
F-75008 Paris(FR)**

(54) Perfectionnement aux résonateurs piézoélectriques.

(57) La présente invention concerne un résonateur piézoélectrique constitué par une lame (1) en un matériau piézoélectrique comportant au moins deux électrodes métalliques (2, 2') et une plaque-support (3) pour recevoir la lame, la lame et/ou la plaque-support étant profilée pour permettre la vibration de la lame et la plaque-support étant réalisée en un matériau mono ou polycristallin à base d'oxydes ou de polymères.

# FIG_2

EP 0 234 153 A1

## PERFECTIONNEMENT AUX RESONATEURS PIEZOELECTRIQUES

La présente invention se rapporte au domaine des résonateurs piézoélectriques constitués d'une lame en un matériau apte à manifester le phénomène connu sous le nom de piézoélectricité, cette lame étant munie sur deux de ses faces en vis-à-vis d'électrodes métalliques permettant de lui appliquer des tensions électriques déterminant la mise en résonance mécanique de la lame.

La présente invention concerne plus particulièrement le montage de ces dites lames piézoélectriques.

Classiquement, les lames piézoélectriques sont montées sur une embase par l'intermédiaire de poteaux ou moyens similaires qui viennent se fixer sur la périphérie de la lame, ces poteaux maintenant la lame en suspension de manière à permettre sa vibration. Pour connecter électriquement les électrodes réalisées sur deux des faces de la lame, au moins deux des poteaux sont réalisés en un matériau électriquement conducteur et sont reliés aux électrodes.

Ce type de montage présente de nombreux inconvénients. Ainsi, on constate que les performances des résonateurs utilisant ce type de montage sont assez médiocres notamment en ce qui concerne la sensibilité aux accélérations et la résistance aux chocs. D'une manière générale, pour les lames de quartz actuellement disponibles sur le marché, la sensibilité aux accélérations des résonateurs ainsi obtenue n'est pas inférieure à $1 \times 10^{-9}/G$. De plus, dans le cas où une sensibilité inférieure à $1 \times 10^{-9}/G$ peut être obtenue, notamment dans le cas des résonateurs auto-suspendus, on constate une grande dispersion de la valeur de la sensibilité dans un même lot de fabrication.

D'autre part, le type de montage décrit ci-dessus est peu résistant mécaniquement et les résonateurs ainsi obtenus ne peuvent être utilisés dans des environnements sévères.

On a déjà proposé dans le brevet américain n° 4287447, un nouveau type de montage des lames piézoélectriques, à savoir un montage à plat. Dans ce cas, le support comporte deux parties latérales présentant une structure en escalier pour recevoir des lames de différents diamètres, les deux parties latérales étant reliées par une plaque centrale. Ce support est réalisé soit en métal, soit en plastique. Toutefois, avec ce support on observe des problèmes de fixation de la lame.

La présente invention a donc pour but de remédier aux inconvénients ci-dessus en proposant un nouveau support permettant un montage à plat des lames piézoélectriques.

En conséquence, la présente invention a pour objet un résonateur piézoélectrique constitué par une lame en un matériau piézoélectriques comportant au moins deux électrodes métalliques et une plaque-support pour recevoir directement la lame, la lame et/ou la plaque-support étant profilée pour permettre la vibration de la lame, caractérisé en ce que la plaque-support est réalisée en un matériau mono ou polycristallin à base d'oxydes ou de polymères tel que quartz, alumine, oxyde de beryllium, le produit vendu sous la marque "Kapton", ou similaire.

D'autre part, selon un mode de réalisation préférentiel, la plaque-support est réalisée en un matériau piézoélectrique identique à celui utilisé pour la fabrication de la lame vibrante.

Selon une autre caractéristique de la présente invention, le montage de la lame vibrante sur la plaque-support est réalisé de telle sorte que la position des axes cristallographiques X, Y, Z de la lame coïncident avec les mêmes axes cristallographiques X, Y, Z de la plaque-support. Ceci évite les dilatations différentielles qui existent entre la lame vibrante et ses fixations si celles-ci sont en un matériau différent.

Si la lame piézoélectrique est plane ou du type décrit dans les demandes de brevet français n°83.15652, n°83.15653 et n°83.15654 déposées conjointement par la demanderesse le 30 Septembre 1983, la plaque-support est évidée dans sa partie centrale du côté supportant la lame pour permettre la vibration d'une telle lame. Toutefois, si la lame piézoélectrique est une lame amincie dans sa partie centrale, comme la lame piézoélectrique décrite dans la demande de brevet français n°82.09511 au nom de la demanderesse, alors la plaque-support peut être plane. Il est évident pour l'homme de l'art que, dans ce cas, la plaque-support peut aussi être évidée dans sa partie centrale comme avec les lames piézoélectriques planes.

Selon une autre caractéristique de la présente invention, pour pouvoir réaliser les liaisons électriques entre les électrodes de la lame piézoélectrique et l'extérieur, au moins les parties de la plaque-support au contact des électrodes sont métallisées ou bien la plaque-support comporte des liaisons métalliques de connexion vers l'extérieur. D'autre part, pour pouvoir réaliser de manière connue l'ajustage en fréquence du résonateur piézoélectrique, la plaque-support peut être munie d'orifices de géométrie variable permettant cet ajustage.

Selon une caractéristique supplémentaire de la présente invention, la plaque-support est montée, de préférence scellée, sur une embase de type connu.

Selon encore une autre caractéristique de la présente invention, un capot en un matériau mono ou polycristallin à base d'oxydes ou de polymères recouvrant la lame est monté sur la plaque-support. Ce capot a pour rôle principal de réduire les capacités parasites Γ. D'autre part, il peut être utilisé pour supporter un circuit électronique supplémentaire tel qu'un circuit de compensation en température.

D'autres caractéristiques et avantages de la présente invention apparaîtront à la lecture de la description d'un mode de réalisation faite ci-après avec référence aux dessins ci-annexés dans lesquels:

-la figure 1 est une vue en plan de dessus d'un résonateur piézoélectrique conforme à la présente invention,

- la figure 2 est une vue en coupe par II-II de figure 1.

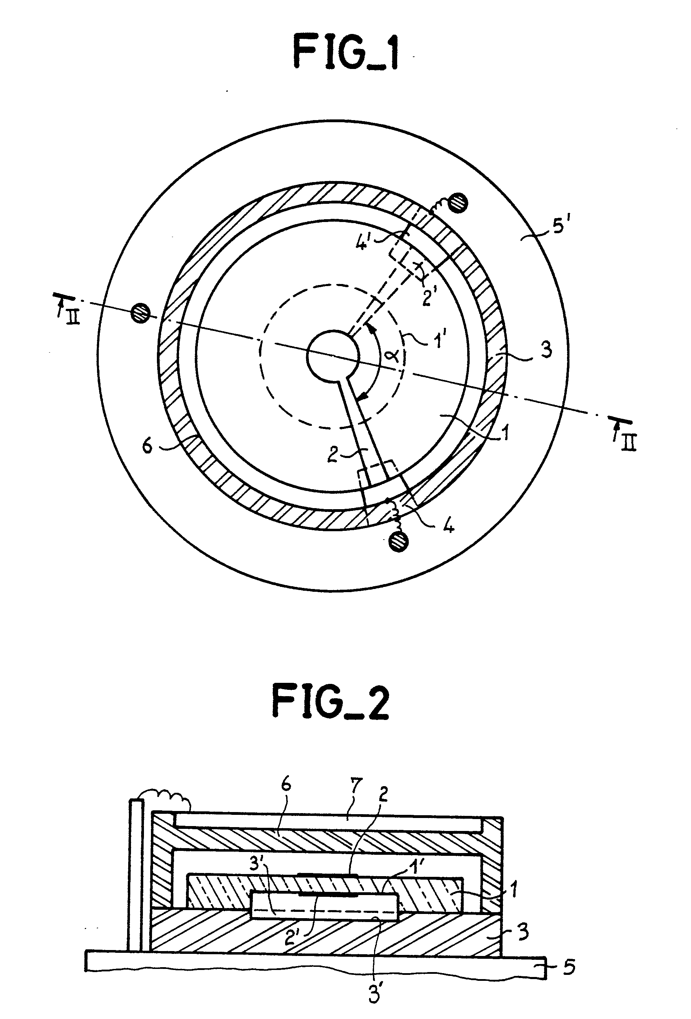

Comme représenté sur les figures 1 et 2, le résonateur piézoélectrique conforme à la présente invention est constitué principalement d'une lame piézoélectrique 1 qui, dans le mode de réalisation représenté, est formée d'un disque comportant une région périphérique non amincie, entourant une région amincie 1'. De manière connue, la région amincie 1' peut être réalisée par usinage ionique. D'autre part, chaque face de la partie centrale de la région amincie 1' est revêtue d'une électrode métallique adhérente 2-2' déposée de manière connue en soi. Chaque électrode 2-2' de forme circulaire se prolonge jusqu'à la périphérie du disque par une partie triangulaire comme représenté sur la figure 1. Diverses dispositions peuvent être adoptées pour les électrodes 2-2'. Ainsi, elles peuvent former entre elles un angle α comme représenté sur la figure 1, ou bien être diposées dans le prolongement l'une de l'autre.

Conformément à la présente invention, cette lame piézoélectrique 1 est montée sur une plaque-support 3 réalisée en un matériau mono ou polycristallin à base d'oxydes ou de polymères tels que l'oxyde de béryllium, l'alumine ou des matériaux similaires. Cette plaque-support est une plaque isolante. De préférence, cette plaque-support est réalisée en un matériau piézoélectrique identique à celui utilisé pour la fabrication de la lame vibrante. D'autre part, la lame piézoélectrique 1 est montée sur la plaque-support 3 de telle sorte que la position des axes cristallographiques X, Y, Z de la lame coïncident avec les mêmes axes cristallographiques X, Y, Z de la plaque-support. Comme représenté clairement sur la figure 2, la plaque-support 3 est évidée dans sa partie centrale 3' du côté de la lame, pour permettre la vibration de cette lame piézoélectrique. En fait, l'évidement 3' est nécessaire lorsque la lame piézoélectrique est une lame entièrement plate, mais dans le cas de la lame piézoélectrique représentée sur la figure 2, c'est-à-dire dans le cas d'une lame piézoélectrique amincie dans sa partie centrale, une plaque-support 3 dont la surface supérieure serait plane comme symbolisé par les tiretés sur la figure 2, peut aussi être utilisée.

Conformément à la présente invention, pour pouvoir connecter électriquement les électrodes à un circuit extérieur, la plaque-support 3 est soit métallisée au niveau de ses partie 4, 4' en contact avec les électrodes, soit munie de liaisons métalliques. Dans ce cas la lame piézoélectrique 1 est scellée sur les métallisations 4-4' à l'aide d'une pâte de scellement conductrice de type connu telle qu'une résine époxy munie de particules conductrices.

Selon une autre caractéristique de la présente invention, l'ensemble lame 1 -plaque-support 3 peut être monté sur une embase 5 de type connu, la fixation de la plaque-support 3 sur l'embase 5 étant réalisée à l'aide d'un matériau de scellement.

D'autre part, comme représenté clairement sur la figure 2, un capot en un matériau mono ou polycristallin à base d'oxydes ou de polymères identique ou du même type que le matériau utilisé pour la plaque-support 3 peut être monté sur ladite plaque en recouvrant la lame piézoélectrique 1. L'objet de ce capot est d'éviter les capacités parasites. Toutefois, ce capot peut être muni sur sa partie supérieure d'un évidement central lui permettant de recevoir un circuit électronique symbolisé par la référence 7 sur la figure 2 tel qu'un circuit permettant de régler la température de l'enceinte ou autre circuit connu de l'homme de l'art. Ce circuit peut être relié électriquement à des poteaux conducteurs 8 fixés sur l'embase 5.

Pour mieux comprendre les avantages de la présente invention, on donnera ci-après un exemple de réalisation pratique d'un résonateur piézoélectrique ainsi que les résultats de mesures effectuées sur cet exemple, en particulier au niveau de la sensibilité aux accélérations.

Exemples de réalisation :

I -On a réalisé un résonateur conforme à la présente invention à partir d'une lame de 5 mm de diamètre en quartz, amincie en sa partie centrale par usinage ionique. Cette lame a été montée conformément à l'invention sur une plaque-support en alumine.

Les caractéristiques du résonateur sont les suivantes:

F = 100 MHz

R = 40 Ω, R étant la résistance motionnelle du quartz

$\Gamma < 0,5$ pF

Q = 100 000

Boîtiers : norme UTE n° 12 A, 13 A, 15 A.

S/G = $5 \cdot 10^{-19}$/G.

    II -On a réalisé un résonateur conforme à la présente invention à partir d'une lame de 5 mm de diamètre en quartz, amincie en sa partie centrale par usinage ionique.

    Cette lame a été montée conformément à un mode de réalisation préférentiel sur une plaque-support en quartz.

    Les caractéristiques du résonateur sont les suivantes :

Fréquence : 100 000 KHz

coupe   : SC

mode    : P 3

R       : $40\Omega$

Q       : 120 000

S/G    : $5 \cdot 10^{-19}$/G.

## Revendications

1. Un résonateur piézoélectrique constitué par une lame (1) en un matériau piézoélectrique comportant au moins deux électrodes métalliques (2, 11), et une plaque-support (3) pour recevoir la lame, la lame et/ou la plaque-support étant profilée pour permettre la vibration de la lame caractérisé en ce que la plaque-support (3) est réalisée en un matériau mono ou polycristallin à base d'oxydes ou de polymères.

2. Un résonateur selon la revendication 1, caractérisé en ce que la plaque-support est réalisée en un matériau piézoélectrique identique à celui de la lame.

3. Un résonateur selon la revendication 2, caractérisé en ce que la lame (1) est montée sur la plaque-support (3) de manière que la position des axes cristallographiques X, Y, Z de la lame coïncident avec les mêmes axes cristallographiques X, Y, Z de la plaque-support.

4. Un résonateur selon l'une quelconque des revendications 1 à 3, caractérisé en ce que la lame piézoélectrique est une lame amincie dans sa partie centrale.

5. Un résonateur selon l'une quelconque des revendications 1 à 4, caractérisé en ce que la plaque-support est évidée dans sa partie centrale - (3') du côté supportant la lame.

6. Un résonateur selon l'une quelconque des revendications 1 à 5, caractérisé en ce qu'au moins les parties de la plaque-support au contact des électrodes sont métallisées.

7. Un résonateur selon l'une quelconque des revendications 1 à 5, caractérisé en ce que la plaque-support comporte des liaisons métalliques de connexion avec l'extérieur.

8. Un résonateur selon l'une quelconque des revendications 1 à 7, caractérisé en ce que la plaque-support est munie d'orifices de géométrie déterminée.

9. Un résonateur selon l'une quelconque des revendications 1 à 8, caractérisé en ce que la plaque-support (3) est montée sur une embase (5).

10. Un résonateur selon l'une quelconque des revendications 1 à 9, caractérisé en ce qu'un capot en un matériau mono ou polycristallin à base d'oxydes ou de polymères, recouvrant la lame est monté sur la plaque-support.

11. Un résonateur selon l'une quelconque des revendications 1 à 9, caractérisé en ce que les électrodes de la lame sont scellées sur les métallisations ou les liaisons métalliques de la plaque-support par l'intermédiaire d'un matériau de scellement conducteur.

12. Un résonateur selon les revendications 1 et 10, caractérisé en ce que le matériau de la plaque-support et du capot est choisi parmi l'oxyde de béryllium, l'alumine, le quartz ou le "Kapton".

# FIG_1

# FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 287 447 (W.G. SKODA et al.)<br><br>* Figures 2A,2B,3A; colonne 3, ligne 59 - colonne 5, ligne 65; colonne 6, lignes 11-55 * | 1-3,5 7,9,11 ,12 | H 03 H   9/05 |
| Y | US-A-3 339 091 (D.L. HAMMOND et al.)<br><br>* En entier * | 1-3,5 7,9,11 ,12 | |
| D,A | EP-A-0 096 611 (COMPAGNIE D'ELECTRONIQUE ET DE PIEZO-ELECTRICITE)<br>* Figures 1,2; page 4, lignes 7-22 * | 4 | |
| | | | DOMAINES TECHNIQUES RECHERCHES (Int. Cl.4) |
| A | US-A-4 293 986 (MASATOSHI KOBAYASHI et al.)<br>* Figure 6; colonne 7, lignes 22-36 * | 10,12 | H 03 H |

Le présent rapport de recherche a été établi pour toutes les revendications

| Lieu de la recherche | Date d'achèvement de la recherche | Examinateur |
|---|---|---|
| LA HAYE | 02-04-1987 | COPPIETERS C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82